# DEMANDE DE BREVET EUROPEEN

(11) **EP 0 678 916 A1**
(43) Date de publication de la demande: **25.10.1995**
(21) Numéro de dépôt: 95400867.8
(22) Date de dépôt: 19.04.1995
(51) Int. Cl.: H01L 23/053, H01L 23/495, H01L 23/24

(54) **Dispositif de puissance à semiconducteur à double isolation**

(30) Priorité: 20.04.1994 FR 9404718
(71) Demandeur: R.V. Electronique, F-77440 Lizy-sur-Ourq (FR)
(72) Inventeur: Vulpillat, Roland, F-93340 Le Raincy (FR)
(74) Mandataire: Thévenet, Jean-Bruno

(57) **Abrégé**

La présente invention se rapporte à un dispositif de puissance à semiconducteur comportant un boîter (2) à l'intérieur duquel est placé un élément semiconducteur (1) fixé sur un premier matériau isolant (3) comprenant des faces supérieure (30) et inférieure (32) métallisées, des bornes de sortie (14,16,18) du dispositif étant en contact avec les différentes couches de l'élément semiconducteur. Selon l'invention, ce dispositif comporte en outre un second matériau isolant (4) comprenant des faces supérieure (40) et inférieure (42) metallisées et disposé entre le premier matériau isolant et le boîter, une borne complémentaire (20) de sortie du dispositif étant en contact avec une des faces métalliques présente à la jonction des premier et second matériaux isolants. Avantageusement, l'élément semiconducteur et les premier et second matériaux isolants sont recouverts d'une résine isolante. L'invention concerne également un ensemble de traitement des signaux d'un dispositif de puissance selon l'invention comportant un circuit de détection du courant traversant une impédance de valeur déterminée disposée entre la borne de sortie complémentaire du dispositif de puissance et un potentiel de référence. De préférence, le circuit de détection commande une alarme ou tout dispositif destiné à améliorer la sécurité de fonctionnement et la protection des personnes.

## Description

La présente invention se rapporte à un dispositif de puissance à semiconducteur comme par exemple une diode ou un transistor de puissance, un IGBT (Transistor Bipolaire à Grille Isolée), un thyristor, un triac, un MCT (Thyristor commandé) ou encore un GTO (Thyristor blocable) ou par exemple un assemblage concentré de dispositifs comme ci-dessus cités.

Il est connu que l'encapsulation d'un semi-conducteur de puissance dans un boîtier métallique peut se faire en soudant directement la pastille (puce) sur l'embase métallique du boîtier, ce qui crée un contact électrique et thermique direct

Ceci présente des avantages pour la liaison thermique et électrique au boîtier en améliorant a priori les possibilités de refroidissement. Toutefois, compte tenu du potentiel électrique auquel est alors porté le boîtier, un isolement extérieur par rapport au dissipateur supportant ce boîtier devient indispensable, ce qui en fait réduit considérablement ces avantages. Notamment, il est bien connu de placer entre le boîtier métallique et l'élément métallique de refroidissement et de fixation (le dissipateur) une plaquette isolante, par exemple en mica, la solidarisation du boîtier sur l'élément étant réalisée par une fixation non conductrice.

Toutefois, cet isolement extérieur n'est pas sans inconvénient du fait tant de sa fragilité, car il est non protégé, que de sa vulnérabilité, car il est soumis à l'atmosphère extérieure. En outre, il est parfois difficile à mettre en oeuvre avec une qualité répétitive et nécessite une opération de main-d'oeuvre délicate compte tenu de la complexité du montage qu'il implique

Par ailleurs, il doit être noté que, de par l'absence de protection de la plaquette isolante, celle-ci présente une grande vulnérabilité mécanique et chimique. Notamment, les différents phénomènes de condensation susceptibles d'affecter l'environnement immédiat du dispositif sont de nature à limiter la tenue de cet isolant dans le temps, voire dans les cas extrêmes, à provoquer sa rupture. Or, cette dernière ne saurait être envisagée dans des ambiances agressives où une telle rupture est de nature à provoquer un arc électrique aux conséquences dommageables non seulement pour le dispositif mais aussi pour l'équipement qui l'entoure, ces dommages pouvant être particulièrement destructeurs si l'ambiance comporte des composés explosifs.

Aussi, une autre solution consiste à monter le dispositif à semiconducteur directement sur l'élément métallique de refroidissement et de fixation, l'ensemble étant alors placé dans une enceinte isolée.

Toutefois, cette solution présente l'inconvénient majeur d'aboutir à une structure lourde particulièrement pénalisante en matière de coût et de volume.

Pour ces différentes raisons, les fabricants de semi-conducteurs de puissance ont intégré l'isolement à l'intérieur même du boîtier et, de fait, de nombreux produits existent sur le marché.

Malheureusement, ce simple isolement est, actuellement, et pour un certain nombre d'applications, insuffisant, soit au regard des normes en vigueur, soit pour des raisons liées à la technique même des produits utilisant ces semi-conducteurs de puissance et il est nécessaire d'avoir un double isolement par rapport au dissipateur qui doit être protégé efficacement contre toute liaison à potentiel électrique.

L'objet de la présente invention est donc de réaliser un dispositif à semiconducteur dont l'isolation ne souffre d'aucun des inconvénients précités mais au contraire soit suffisamment fiable pour être mis en oeuvre dans les environnements les plus sévères. Un but de l'invention est aussi de proposer un dispositif de puissance qui puisse s'insérer facilement dans les équipements existants et soit facile à monter comme à raccorder.

Ces buts sont atteints par un dispositif de puissance à semiconducteur comportant un boîtier à l'intérieur duquel est placé un élément semiconducteur fixé sur un premier matériau isolant comprenant des faces supérieure et inférieure métallisées, des bornes de sortie du dispositif étant en contact avec les différentes couches de l'élément semiconducteur, ce dispositif de puissance comportant en outre un second matériau isolant comprenant des faces supérieure et inférieure métallisées et disposé entre le premier matériau isolant et le boîtier, une borne complémentaire de sortie du dispositif étant en contact avec une des faces métalliques présente à la jonction des premier et second matériaux isolants.

De préférence, notamment afin d'accroître la durée de vie du dispositif de puissance, l'élément semiconducteur et les premier et second matériaux isolants sont recouverts d'une résine isolante.

La présente invention concerne également l'ensemble de traitement des signaux mis en oeuvre avec le dispositif de puissance selon l'invention. Afin d'exploiter au mieux la structure particulière de ce dispositif de puissance, cet ensemble comporte un circuit de détection du courant traversant une impédance de valeur déterminée disposée entre la borne de sortie complémentaire du dispositif de puissance et un potentiel de référence. Avantageusement, le circuit de détection commande une alarme ou tout dispositif destiné à améliorer la sécurité de fonctionnement et la protection des personnes, qui peut ainsi prévenir au premier défaut l'utilisateur de toute défaillance interne (rupture d'une couche isolante) du dispositif.

D'autres caractéristiques et avantages de la présente invention ressortiront mieux de la description suivante, faite à titre indicatif et non limitatif, en regard des dessins annexés, sur lesquels:
- la figure 1 montre la structure d'un dispositif de puissance à semiconducteur selon l'invention,
- la figure 2 représente une vue extérieure avec arrachement partiel d'un exemple de réalisation du dispositif de la figure 1 appliqué à un dispositif de puissance du type triac,
- la figure 3 est un autre exemple de réalisation d'un dispositif selon l'invention, et
- la figure 4 est un schéma électrique simplifié d'un exemple de mise en oeuvre du dispositif de la figure 2.

Dans un dispositif de puissance à semiconducteur classique, comme un thyristor par exemple, l'élément semiconducteur (la puce 1) qui est disposé dans un boîtier ou châssis 2 et isolé de celui-ci par une couche d'un matériau isolant (de préférence une fine lamelle en céramique ou en alumine) comporte sur sa partie inférieure 10 un revêtement métallique constituant l'anode, et la cathode ainsi que la gâchette sont réalisées sur sa partie supérieure 12. La cathode, la gâchette et l'anode sont reliées, par exemple par soudure, respectivement à des bornes de sortie 14, 16, 18.

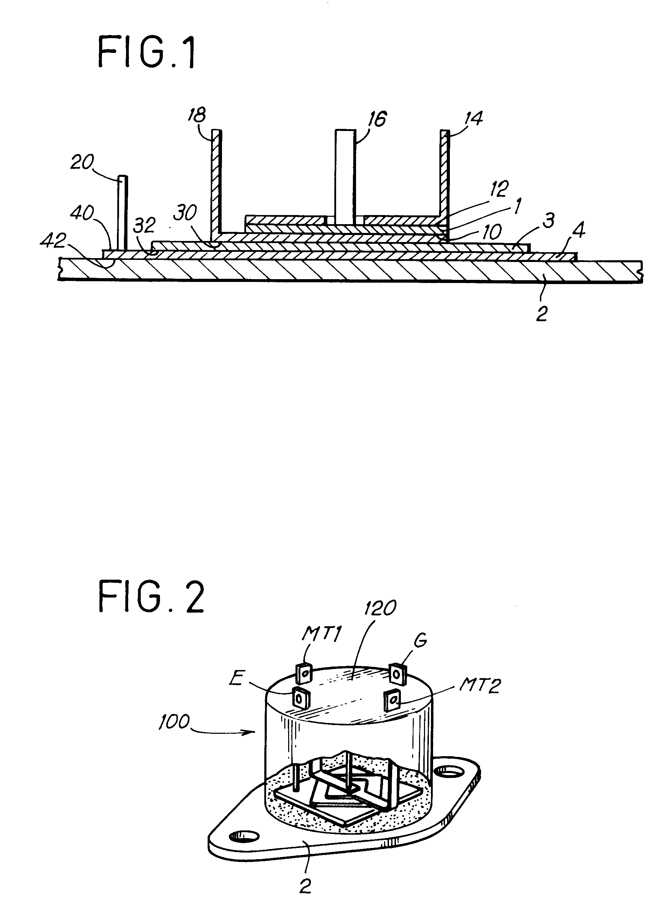

Dans le dispositif de puissance selon l'invention, également du type thyristor, tel que le représente la figure 1, la borne d'anode 18 est placée sur un premier matériau isolant 3 (formé par une pastille en alumine par exemple) qui lui-même recouvre un second matériau isolant 4 disposé sur le fond du boîtier 2. Afin de permettre une solidarisation, notamment par soudure, des éléments précités, ces deux matériaux isolants sont partiellement recouverts d'une surface métallique sur leurs parties supérieure 30 (respectivement 40) et inférieure 32 (42). Une des surfaces métalliques comprise entre les premier et second matériaux isolants, de préférence la surface métallique supérieure 40 de la seconde couche 4, est reliée à une borne de sortie supplémentaire 20 que l'on dénommera borne d'écran.

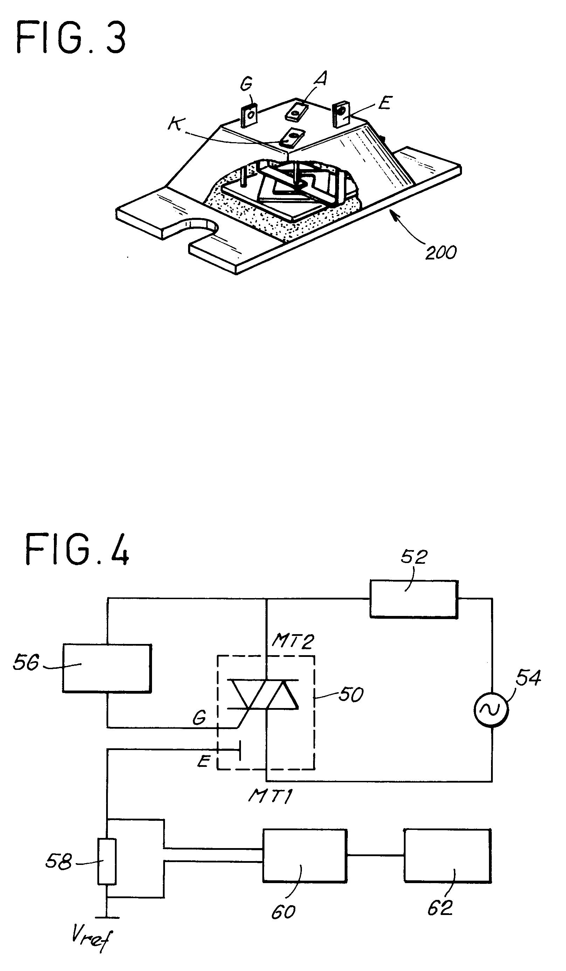

Comme il peut être observé sur les figures 2 et 3, qui montrent, en vue extérieure avec une partie arrachée, d'une part un dispositif de puissance du type triac et d'autre part un dispositif de puissance du type thyristor, la structure de l'invention s'adapte parfaitement à tout type de boîtier connu. Ainsi, sur la figure 2, une structure analogue à celle de la figure 1 est montée dans un boîtier 100 à l'intérieur duquel est coulée une résine isolante 120 et duquel émergent quatre bornes de sortie, les bornes de sortie principale 1 (MT1) et de sortie principale 2 (MT2), la borne de gâchette G et une borne supplémentaire de sortie écran E (dans un triac classique seules les trois premières sont présentes). Sur la figure 3, la structure de la figure 1 est montée dans un boîtier 200, les bornes d'anode A, de cathode K, de gâchette G et d'écran E apparaissant alors sur le dessus du boîtier.

Il est donc clair que la structure de la figure 1 est adaptable très simplement à de nombreux boîtiers existants sans aucune nécessité d'en modifier les dimensions, l'adjonction de la borne d'écran supplémentaire comme celle du second matériau isolant pouvant être réalisée lors du processus d'encapsulation de l'élément semiconducteur selon des techniques classiques connues et donc sans en accroître le coût global.

Le fonctionnement de ce thyristor est bien évidemment identique à un thyristor classique dont il conserve les propriétés physiques et électriques mais il bénéficie en outre des avantages spécifiques liés à la double isolation de l'élément semiconducteur 1 par les premier et second matériaux isolants 3, 4. Notamment, et contrairement aux dispositifs de l'art antérieur, du fait de la présence du second matériau isolant, l'utilisateur se trouve protégé contre une rupture du premier matériau isolant qui avait pour conséquence de porter le boîtier, initialement au potentiel de la masse, à un potentiel élevé compte tenu des hautes tensions mises en jeu dans ce type de dispositif de puissance (couramment de quelques dizaines de volts à plusieurs kilovolts). Bien évidemment, les dimensions de ces matériaux seront déterminées de telle sorte qu'ils assurent en outre une excellente diffusion (constantes de temps thermiques les plus faibles possibles) de la chaleur produite par l'élément semiconducteur en créant une chaîne continue de celui-ci à l'atmosphère extérieure.

Un exemple typique de commande d'une charge électrique (source lumineuse ou moteur électrique par exemple) est donné à la figure 4. Le dispositif de puissance à semiconducteur, en l'espèce un triac 50, est classiquement placé (au travers de ses bornes MT1 et MT2) dans le circuit de la charge à commander 52 (une lampe, une résistance de chauffage, l'induit d'un moteur, etc) entre une borne de la tension d'alimentation 54 et une borne de cette charge, l'autre borne de la charge étant reliée à l'autre borne de la tension d'alimentation. La borne de gâchette G du triac est quant à elle reliée à un circuit de commande 56 à même de faire varier l'angle de conduction de ce triac. Dans le cadre de l'invention, la borne supplémentaire d'écran de ce triac est reliée à un potentiel de référence Vref au travers d'une impédance 58. Un circuit de détection 60, placé de préférence aux bornes de l'impédance, détecte le courant traversant cette impédance et produit si nécessaire un signal de commande pour une alarme 62. Cette alarme peut être de toute nature, visuelle ou sonore, ou bien encore elle peut consister en un disjoncteur électronique.

Le fonctionnement de ce circuit et son intérêt seront compris aisément. En absence de dysfonctionnement du triac 50, aucun courant ne circule dans l'impédance 58 et l'écran est mis au potentiel de référence. Au contraire, dès que le triac est l'objet d'un premier défaut d'isolement quelconque (début de rupture du premier matériau isolant par exemple), il se crée un courant dans l'impédance qui est alors automatiquement détecté par le circuit 60, lequel peut générer la procédure d'alerte préalablement convenue (avertissement de l'utilisateur ou remplacement automatique des circuits défectueux) et ainsi éviter une destruction ultérieure totale du dispositif de puissance comme de son environnement. Il est à noter que ce premier défaut ne met pas en cause le fonctionnement et la protection extérieure du dispositif ou des personnes par le fait de la présence du second isolement dont on voit, en particulier ici, tout l'avantage. Par ce circuit de détection, il est ainsi créé un contrôle permanent de la qualité de l'isolement. Il est en outre intéressant de noter que la présence de cet écran améliore l'isolation des circuits extérieurs par rapport aux différents parasites résultant des commutations rapides du dispositif, ce qui contribue à une amélioration globale de la protection contre les rayonnements CEM (compatibilité électromagnétique).

## Revendications

1. Dispositif de puissance à semiconducteur comportant un boîtier muni d'un fond de boîtier (2) conducteur de l'électricité et de la chaleur à l'intérieur duquel est placé un élément semiconducteur (1) fixé sur un premier matériau isolant (3) comprenant des faces supérieure (30) et inférieure (32) métallisées conductrices, des bornes de sortie (14,16,18) du dispositif étant en contact avec les différentes couches de l'élément semiconducteur (1),
caractérisé en ce qu'il comporte en outre un second matériau isolant (4) comprenant des faces supérieure (40) et inférieure (42) métallisées conductrices et disposé entre le premier matériau isolant (3) et le fond de boîtier (2), une borne complémentaire (20, E) de sortie du dispositif étant en contact avec une des faces métalliques (32, 40) présente à la jonction des premier et second matériaux isolants.

2. Dispositif de puissance selon la revendication 1, caractérisé en ce que ladite borne complémentaire (20, E) est reliée à un dispositif externe (60) détecteur de courant afin de générer une procédure de mesure et/ou d'alerte en cas de défaut d'isolement du premier matériau isolant (3).

3. Ensemble de traitement des signaux d'un dispositif de puissance selon la revendication 1 ou la revendication 2, caractérisé en ce qu'il comporte un circuit (60) de détection du courant traversant une impédance (58) de valeur déterminée disposée entre la borne de sortie complémentaire du dispositif de puissance et un potentiel de référence.

4. Ensemble de traitement selon la revendication 3, caractérisé en ce que le circuit de détection (60) commande une alarme (62) ou tout autre dispositif destiné à assurer un contrôle de la qualité de l'isolement, et à améliorer la sécurité de fonctionnement et la protection des personnes.
